(19) Europäisches Patentamt
European Patent Office
Office européen des brevets

(11) **EP 2 672 516 A1**

(12) **EUROPEAN PATENT APPLICATION**
published in accordance with Art. 153(4) EPC

(43) Date of publication:
**11.12.2013 Bulletin 2013/50**

(51) Int Cl.:
*H01L 29/12* (2006.01)    *H01L 21/336* (2006.01)
*H01L 29/78* (2006.01)

(21) Application number: **11857887.1**

(22) Date of filing: **05.10.2011**

(86) International application number:
**PCT/JP2011/072992**

(87) International publication number:
**WO 2012/105088 (09.08.2012 Gazette 2012/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.02.2011   JP 2011019372**

(71) Applicant: **Sumitomo Electric Industries, Ltd.**
**Osaka-shi, Osaka 541-0041 (JP)**

(72) Inventors:
• **MASUDA, Takeyoshi**
  **Osaka-shi**
  **Osaka 554-0024 (JP)**
• **HIYOSHI, Toru**
  **Osaka-shi**
  **Osaka 554-0024 (JP)**
• **WADA, Keiji**
  **Osaka-shi**
  **Osaka 554-0024 (JP)**

(74) Representative: **Grünecker, Kinkeldey,**
**Stockmair & Schwanhäusser**
**Leopoldstrasse 4**
**80802 München (DE)**

(54)   **SEMICONDUCTOR DEVICE**

(57)   A MOSFET (1) includes a silicon carbide substrate (10), an active layer (20), a gate oxide film (30), and a gate electrode (40). The active layer (20) includes a p type body region (22) in which an inversion layer is formed when the gate electrode (40) is fed with a voltage. The inversion layer has an electron mobility $\mu$ dependent more strongly on an acceptor concentration $N_a$ of a channel region (29) of the p type body region (22), as compared with a dependency of the electron mobility $\mu$ being proportional to the reciprocal of the acceptor concentration $N_a$. The acceptor concentration $N_a$ in the channel region (29) of the p type body region (22) is not less than $1 \times 10^{16}$ cm$^{-3}$ and not more than $2 \times 10^{18}$ cm$^{-3}$. The channel length (L) is equal to or smaller than 0.43 $\mu$m. The channel length (L) is equal to or longer than a spreading width d of a depletion layer in the channel region (29). The spreading width d is expressed by $d = D \cdot N_a^{-C}$.

FIG.1

**Description**

TECHNICAL FIELD

The present invention relates to a semiconductor device, more particularly, a semiconductor device allowing for reduced channel resistance.

BACKGROUND ART

In recent years, in order to achieve high breakdown voltage, low loss, and utilization of semiconductor devices under a high temperature environment, silicon carbide has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have a high breakdown voltage, reduced on-resistance, and the like. Further, the semiconductor device thus adopting silicon carbide as its material has characteristics less deteriorated even under a high temperature environment than those of a semiconductor device adopting silicon as its material, advantageously.

Various studies have been conducted to achieve improved channel mobility and reduced on-resistance in semiconductor devices, each of which employs silicon carbide as its material as described above and controls existence and non-existence of an inversion layer in a channel region in accordance with a predetermined threshold voltage so as to conduct and interrupt a current. Examples of such semiconductor devices include a MOSFET (Metal Oxide Semiconductor Field Effect Transistor) and an IGBT (Insulated Gate Bipolar Transistor). (See, for example, Japanese Patent Laying-Open No. 2000-150866 (Patent Literature 1); Fujihira et al., "Realization of Low On-Resistance 4H-SiC power MOSFETs by Using Retrograde Profile in P-Body", Materials Science Forum, Vols.556-557, Silicon Carbide and Related Materials 2006, 2006, p.827-830 (Non-Patent Literature 1); and Sei-Hyung Ryu et al., "Critical Issues for MOS Based Power Devices in 4H-SiC", Materials Science Forum, Vols.615-617, 2009, p.743-748 (Non-Patent Literature 2)).

CITATION LIST

PATENT LITERATURE

PTL 1: Japanese Patent Laying-Open No. 2000-150866

NON PATENT LITERATURE

NPL 1: Fujihira et al., "Realization of Low On-Resistance 4H-SiC power MOSFETs by Using Retrograde Profile in P-Body", Materials Science Forum, Vols.556-557, Silicon Carbide and Related Materials 2006, 2006, p.827-830
NPL 2: Sei-Hyung Ryu et al., "Critical Issues for MOS Based Power Devices in 4H-SiC", Materials Science Forum, Vols.615-617, 2009, p.743-748

SUMMARY OF INVENTION

TECHNICAL PROBLEM

However, the above-described semiconductor devices employing silicon carbide as their material such as a MOSFET and an IGBT are required to have further reduced channel resistance and further suppressed on-resistance.
In view of this, the present invention has its object to provide a semiconductor device allowing for reduced channel resistance.

SOLUTION TO PROBLEM

A semiconductor device in an first aspect of the present invention includes: a substrate made of silicon carbide; an epitaxial growth layer made of silicon carbide and formed on the substrate; a gate insulating film made of an insulator and disposed in contact with the epitaxial growth layer; and a gate electrode disposed in contact with the gate insulating film. The epitaxial growth layer includes a p type body region having p type conductivity and having a region which makes contact with the gate insulating film and in which an inversion layer is formed when the gate electrode is fed with a voltage. The inversion layer has an electron mobility $\mu$ dependent more strongly on an acceptor concentration $N_a$ in the region of the p type body region in which the inversion layer is to be formed, as compared with a dependency of the electron mobility $\mu$ being in proportional to a reciprocal of the acceptor concentration $N_a$. The acceptor concentration $N_a$ in the region of the p type body region in which the inversion layer is to be formed is not less than $1 \times 10^{16}$ cm$^{-3}$ and not more than $2 \times 10^{18}$ cm$^{-3}$. The inversion layer has a channel length of 0.43 $\mu$m or smaller, the channel length being a length thereof in a direction in which electrons are moved in the inversion layer. The channel length is equal to or longer than a spreading width d of a depletion layer in the region of the p type body region in which the inversion layer is to be formed, the spreading width d being expressed by d = $D \cdot N_a^{-C}$, where C and D represent constants.

A semiconductor device in a second aspect of the present invention includes: a substrate made of silicon carbide; an epitaxial growth layer made of silicon carbide and formed on the substrate; a gate insulating film made of an insulator and disposed in contact with the epitaxial growth layer; and a gate electrode disposed in contact with the gate insulating film. The epitaxial growth layer includes a p type body region having p type conductivity and having a region which makes contact with the gate insulating film and in which an inversion layer is formed when the gate electrode is fed with a voltage. The epitaxial growth layer has a surface that faces the gate electrode with the gate insulating film interposed therebetween and that forms an angle of 8° or smaller relative to a (0001) plane of silicon carbide constituting the epitaxial growth layer. An acceptor concentration $N_a$ in the region of the p type body region in which the inversion layer is to be formed is not less than $1 \times 10^{16}$ cm$^{-3}$ and not more than $2 \times 10^{18}$ cm$^{-3}$. The inversion layer has a channel length of 0.43 $\mu$m or smaller, the channel length being a length thereof in a direction in which electrons are moved in the inversion layer. The channel length is equal to or longer than a spreading width d of a depletion layer in the region of the p type body region in which the inversion layer is to be formed, the spreading width d being expressed by d = $D \cdot N_a^{-C}$, where C and D represent constants.

The present inventor has conducted below-described detailed studies to achieve reduced channel resistance in a semiconductor device, and has arrived at the present invention based on the findings obtained therefrom.

Specifically, a ratio of channel resistance in on-resistance is large in a semiconductor device employing silicon carbide as its material. Further, the channel resistance is proportional to a product of reciprocal of channel mobility and channel length. Hence, in order to achieve reduced channel resistance, it is important to improve the channel mobility and shorten the channel length.

In general, the mobility $\mu$ is dominantly influenced by ion scattering, and is in proportional to the reciprocal of acceptor concentration (ion concentration) $N_a$ (see Formula (1)).

$$\mu \propto N_a^{-1} \qquad \qquad \dots (1)$$

However, in addition to the ion scattering, the mobility $\mu$ is influenced by defects and traps produced in ion implantation for forming p type body regions or the like and a post process of the ion implantation, in the case where the surface of the epitaxial growth layer facing the gate electrode with the gate insulating film interposed therebetween corresponds to a plane close to the (0001) plane of silicon carbide constituting the epitaxial growth layer, more specifically, in the case where the surface of the epitaxial growth layer facing the gate electrode with the gate insulating film interposed therebetween forms an angle of 8° or smaller relative to the (0001) plane of silicon carbide constituting the epitaxial growth layer. In such a case, the mobility $\mu$ is accordingly influenced by the acceptor concentration, more strongly. The densities of defects and traps produced during the ion implantation and the post process thereof are dependent on an amount of ions implanted, and can be represented by a function of acceptor concentration $N_a$. According to the studies by the present inventor, the mobility $\mu$ influenced by not only the ion scattering but also the defects and traps can be expressed by the following Formula (2):

$$1/\mu = A \exp(B \cdot N_a) \qquad \qquad \dots (2)$$

In Formula (2), A and B represent coefficients of real numbers.

Meanwhile, the channel resistance is in proportional to the channel length. Hence, by shortening the channel length, the channel resistance can be reduced. However, with the channel length shortened, a short channel effect (punch through) will be produced to result in problems such as reduced breakdown voltage and deteriorated off characteristics. The short channel effect is caused by the depletion layer spreading from a pn junction region, which is formed at an end portion of the channel region, into the channel region so as to form the entire channel region into the depletion layer. Hence, in order to suppress occurrence of the short channel effect, it is necessary to secure a channel length larger than the width of the depletion layer spreading from the pn junction region. When an impurity concentration outside the pn junction region at the end portion of the channel region is constant, the depletion layer spreads into the channel region at a spreading width d, which satisfies the following Formula (3)':

$$d = \sqrt{\frac{2\varepsilon_{sic}\varepsilon_0 (V_d - V_{\max})N_d}{eN_a(N_a + N_d)}} \qquad \ldots (3)'$$

Here, $\varepsilon_{SiC}$ represents a dielectric constant of SiC (silicon carbide), $\varepsilon_0$ represents a dielectric constant of vacuum, $V_d$ represents a diffusion potential, $V_{max}$ represents a maximum voltage applied to the pn junction in the OFF state (a positive value thereof corresponds to a case where the voltage is applied in the forward direction of the pn junction, and a negative value thereof corresponds to a case where the voltage is applied in a reverse direction), $N_d$ represents a donor concentration, and e represents an elementary charge.

Formula (3)' described above can be approximately expressed in the following Formula (3) within a practical range:

$$d = D \cdot N_a^{-C} \qquad \ldots (3)$$

Here, C and D represent constants determined by the structure of the semiconductor device. C is a positive real number and satisfies $0 < C < 1.0$. D is a coefficient of a real number.

Further, channel resistance $R_{ON}$ is in proportion to the reciprocal of the mobility and the channel length, and can be therefore expressed in the following Formula (4):

$$R_{on} \propto d / \mu = D \cdot N_a^{-C} \cdot A \cdot \exp(B \cdot N_a) \qquad \ldots (4)$$

This function takes a minimum value, and $R_{ON}$ is minimum with $N_a = C/B$. In view of general values of A-D in the semiconductor device, when acceptor density $N_a$ is more than $1 \times 10^{16}$ cm$^{-3}$ and is less than $2 \times 10^{18}$ cm$^{-3}$, $R_{ON}$ can be sufficiently reduced. Further, when the minimum acceptor density $N_a$ allowing for the maximum spreading width d of the depletion layer is $1 \times 10^{16}$ cm$^{-3}$ in the above-described range of acceptor density $N_a$, the spreading width d of the depletion layer is found to be 0.43 $\mu$m in accordance with Formula (3). Namely, with the above-described range of acceptor density $N_a$, the channel length does not need to be in a range exceeding 0.43 $\mu$m. The channel length in a range exceeding 0.43 $\mu$m is unnecessarily long to result in increased channel resistance. Hence, the channel length is preferably equal to or smaller than 0.43 $\mu$m. On the other hand, the lower limit value of the channel length can be defined by the lower limit value of a channel length allowing for suppression of the short channel effect. Specifically, the short channel effect can be suppressed by setting the channel length to be equal to or greater than the spreading width d of the depletion layer in the region (channel region 29) of the p type body region in which the inversion layer is to be formed. The spreading width d is expressed by $d = D \cdot N_a^{-C}$.

In the semiconductor device of the present invention, the channel resistance can be effectively reduced while suppressing occurrence of the short channel effect due to the following reasons: the mobility $\mu$ in the inversion layer is dependent on the acceptor concentration $N_a$ more strongly as compared with a dependency of the mobility $\mu$ being in proportional to the reciprocal of the acceptor concentration $N_a$, or the surface of the epitaxial growth layer facing the gate electrode with the gate insulating film interposed therebetween forms an angle of 8° or smaller relative to the (0001) plane of silicon carbide constituting the epitaxial growth layer; the acceptor concentration $N_a$ in the region in which the inversion layer is to be formed is not less than $1 \times 10^{16}$ cm$^{-3}$ and not more than $2 \times 10^{18}$ cm$^{-3}$; and the channel length is not less than d defined by Formula (3) and not more than 0.43 $\mu$m.

Thus, according to the semiconductor device of the present invention, there can be provided a semiconductor device allowing for reduced channel resistance.

In the semiconductor device of the above-described first aspect, a relation between the electron mobility $\mu$ in the inversion layer and the acceptor concentration $N_a$ in the region of the p type body region in which the inversion layer is to be formed may be able to be approximated by $1/\mu = A\exp(B \cdot N_a)$, where A and B represent constants of real numbers.

A semiconductor device satisfying such a condition is particularly suitable for the semiconductor device of the present invention in which the acceptor concentration $N_a$ and the channel length fall within the above-described respective ranges. Here, the expression "able to be approximated by $1/\mu = A\exp(B \cdot N_a)$" refers to a state in which a correlation coefficient is 0.99 or greater in a least square method when a relation of at least four values of acceptor concentration $N_a$ with respect to $1/\mu$ is fitted by the above-described exponential function with only the acceptor concentration $N_a$ being a variable.

In the above-described semiconductor device, a value of B may be more than $1 \times 10^{-19}$ and less than $1 \times 10^{-16}$. Further, in the above-described semiconductor device, a value of A may be more than 0 and less than 2. A semiconductor device satisfying such conditions is particularly suitable for the semiconductor device of the present invention in which the acceptor concentration $N_a$ and the channel length fall within the above-described respective ranges.

In the above-described semiconductor device, values of C and D may satisfy $0.5 < C < 1.0$ and $1 \times 10^{14} < D < 1 \times 10^{16}$, respectively. A semiconductor device satisfying such a condition is particularly suitable for the semiconductor device of the present invention in which the acceptor concentration $N_a$ and the channel length fall within the above-described respective ranges.

In the above-described semiconductor device, the p type body region may include: a high concentration region disposed to include the region in which the inversion layer is to be formed and having a high acceptor concentration; and a low concentration region disposed adjacent to the high concentration region in the direction in which the electrons are moved in the inversion layer, so as to include the region in which the inversion layer is to be formed, the low concentration region having a lower acceptor concentration than that of the high concentration region.

In this way, the high concentration region restrains the spreading width of the depletion layer in the region in which the inversion layer is to be formed, thereby suppressing occurrence of the short channel effect more securely.

In the above-described semiconductor device, the acceptor concentration in the low concentration region is 1/2 or smaller of the acceptor concentration in the high concentration region.

By disposing the high concentration region thus providing the large density difference, the occurrence of the short channel effect can be suppressed more securely.

ADVANTAGEOUS EFFECTS OF INVENTION

As apparent from the description above, according to the semiconductor device of the present invention, there can be provided a semiconductor device allowing for reduced channel resistance.

BRIEF DESCRIPTION OF DRAWINGS

Fig. 1 is a schematic cross sectional view showing a structure of a MOSFET of a first embodiment.
Fig. 2 is a flowchart schematically showing a procedure of manufacturing the MOSFET of the first embodiment.
Fig. 3 is a schematic cross sectional view for illustrating a method for manufacturing the MOSFET.
Fig. 4 is a schematic cross sectional view for illustrating the method for manufacturing the MOSFET.
Fig. 5 is a schematic cross sectional view for illustrating the method for manufacturing the MOSFET.
Fig. 6 is a schematic cross sectional view for illustrating the method for manufacturing the MOSFET.
Fig. 7 is a schematic cross sectional view for illustrating the method for manufacturing the MOSFET.
Fig. 8 is a schematic cross sectional view for illustrating the method for manufacturing the MOSFET.
Fig. 9 is a schematic cross sectional view for illustrating the method for manufacturing the MOSFET.
Fig. 10 is a schematic cross sectional view showing a structure of a MOSFET of a second embodiment.
Fig. 11 is a flowchart schematically showing a procedure of manufacturing the MOSFET of the second embodiment.
Fig. 12 is a schematic cross sectional view for illustrating a method for manufacturing the MOSFET.
Fig. 13 is a schematic cross sectional view for illustrating the method for manufacturing the MOSFET.

DESCRIPTION OF EMBODIMENTS

The following describes embodiments of the present invention with reference to figures. It should be noted that in the below-mentioned figures, the same or corresponding portions are given the same reference characters and are not described repeatedly.

(First Embodiment)

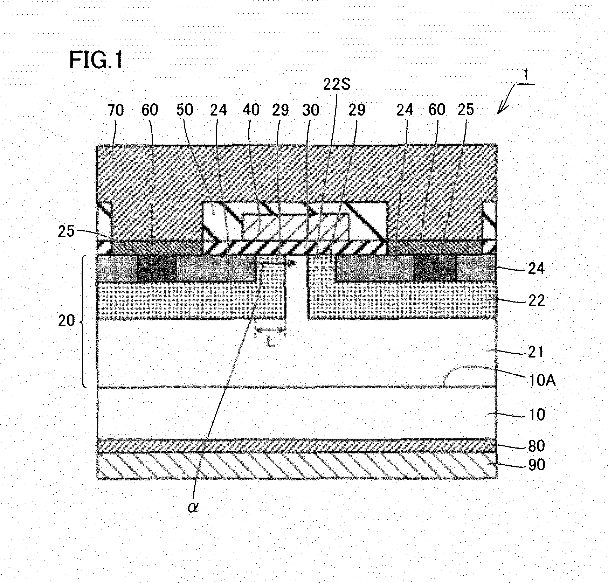

First, a first embodiment, which is one embodiment of the present invention, will be described below with reference to Fig. 1. A MOSFET 1, which is a semiconductor device of the first embodiment, includes a silicon carbide substrate 10 and an active layer 20 disposed on one main surface 10A of silicon carbide substrate 10. Active layer 20 is an epitaxial growth layer made of silicon carbide.

Silicon carbide substrate 10 is made of single-crystal silicon carbide, contains an impurity (n type impurity) such as nitrogen or phosphorus, and therefore has n type conductivity (first conductivity type). Active layer 20 includes a drift layer 21, p type body regions 22, $n^+$ source regions 24, and $p^+$ contact regions 25.

Drift layer 21 is disposed on silicon carbide substrate 10, contains an n type impurity at a concentration lower than that in silicon carbide substrate 10, and therefore has n type conductivity. Each of p type body regions 22 is disposed to include a main surface of active layer 20 opposite to silicon carbide substrate 10. P type body region 22 contains an impurity (p type impurity) such as aluminum or boron and therefore has p type conductivity (second conductivity type). $N^+$ source regions 24 are formed in p type body regions 22 so as to include the main surface of active layer 20 opposite to silicon carbide substrate 10. Each of $n^+$ source regions 24 contains an n type impurity at a concentration higher than that of drift layer 21, and therefore has n type conductivity.

$P^+$ contact regions 25 are formed in p type body regions 22 so as to include the main surface of active layer 20 opposite to silicon carbide substrate 10. Each of $p^+$ contact regions 25 is disposed closer to the center of each of p type body regions 22 when viewed from each of $n^+$ source regions 24. $P^+$ contact region 25 contains a p type impurity and therefore has p type conductivity.

MOSFET 1 further includes: a gate oxide film 30 serving as a gate insulating film; a gate electrode 40; source contact electrodes 60; an interlayer insulating film 50; a source wire 70; a drain contact electrode 80; and a backside surface protecting electrode 90.

Gate oxide film 30 is made of, for example, an insulator such as silicon dioxide, and extends in contact with $n^+$ source regions 24 and p type body regions 22 on the main surface of active layer 20 opposite to silicon carbide substrate 10. Gate electrode 40 is disposed on and in contact with gate oxide film 30, and extends over p type body regions 22. Gate electrode 40 is made of a conductor such as polysilicon or aluminum.

Source contact electrodes 60 are disposed on active layer 20 in contact with $n^+$ source regions 24 and $p^+$ contact regions 25. Source contact electrodes 60 are disposed on active layer 20 in contact with regions not covered with gate oxide film 30. Each of source contact electrodes 60 is made of a conductor such as nickel, and has at least a silicided region that makes contact with active layer 20, thus forming an ohmic contact with each of $n^+$ source regions 24.

Interlayer insulating film 50 is disposed to cover gate electrode 40 and extends to also cover gate oxide film 30. Interlayer insulating film 50 is made of an insulator such as silicon dioxide. Source wire 70 is disposed in contact with source contact electrodes 60 so as to cover source contact electrodes 60 and interlayer insulating film 50. Source wire 70 is made of a conductor such as aluminum.

Drain contact electrode 80 is disposed on and in contact with the main surface of silicon carbide substrate 10 opposite to active layer 20. Drain contact electrode 80 is made of a conductor such as nickel, and has at least a silicided region that makes contact with silicon carbide substrate 10, thereby forming an ohmic contact with silicon carbide substrate 10. Backside surface protecting electrode 90 is disposed on and in contact with drain contact electrode 80 so as to cover drain contact electrode 80. Backside surface protecting electrode 90 is made of a conductor such as aluminum.

The following describes operations of MOSFET 1. Referring to Fig. 1, when each of drain contact electrode 80 and backside surface protecting electrode 90 is fed with a voltage while gate electrode 40 has a voltage smaller than a threshold voltage, i.e., while it is in the OFF state, a pn junction between each of p type body regions 22 and drift layer 21 is reverse-biased. Accordingly, MOSFET I is in the non-conductive state. On the other hand, when gate electrode 40 is fed with a voltage equal to or greater than the threshold voltage, inversion layers are formed in channel regions 29, which are regions near locations at which p type body regions 22 make contact with gate oxide film 30. As a result, $n^+$ source regions 24 and drift layer 21 are electrically connected to one another, whereby electrons serving as carriers are moved along an arrow $\alpha$. Accordingly, a current flows therein.

Thus, MOSFET 1, which is the semiconductor device of the present embodiment, includes: silicon carbide substrate 10; active layer 20 that is made of silicon carbide and is an epitaxial growth layer formed on silicon carbide substrate 10; gate oxide film 30 disposed in contact with active layer 20; and gate electrode 40 disposed in contact with gate oxide film 30. Active layer 20 includes p type body regions 22 having p type conductivity and having channel region 29 which makes contact with gate oxide film 30 and in which the inversion layer is formed when gate electrode 40 is fed with a voltage. In MOSFET 1, the inversion layer has an electron mobility $\mu$ dependent more strongly on an acceptor concentration $N_a$ in channel region 29 of p type body region 22 in which the inversion layer is to be formed, as compared with a dependency of electron mobility $\mu$ being in proportional to the reciprocal of acceptor concentration $N_a$. Acceptor concentration $N_a$ in channel region 29 of p type body region 22 is not less than $1 \times 10^{16}$ cm$^{-3}$ and not more than $2 \times 10^{18}$ cm$^{-3}$. The inversion layer has a channel length L of 0.43 $\mu$m or smaller. Channel length L is a length thereof in a direction $\alpha$ in which electrons are moved in the inversion layer. Channel length L is equal to or longer than spreading width d of a depletion layer in channel region 29. Spreading width d is expressed by: $d = D \cdot N_a^{-C}$.

Further, in MOSFET 1 of the present embodiment, main surface 10A of silicon carbide substrate 10, on which active layer 20 that is an epitaxial growth layer is formed, forms an angle of 8° or smaller relative to the (0001) plane of silicon carbide constituting silicon carbide substrate 10. Accordingly, active layer 20 has a surface 22S facing gate electrode 40 with gate oxide film 30 interposed therebetween and forming an angle of 8° or smaller relative to the (0001) plane of silicon carbide constituting active layer 20. As a result, as described above, the inversion layer has electron mobility $\mu$ dependent more strongly on acceptor concentration $N_a$ in channel region 29 of p type body region 22 in which the inversion layer is to be formed, as compared with the state in which it is in proportion to the reciprocal of acceptor concentration $N_a$.

In MOSFET 1 of the present embodiment, acceptor concentration $N_a$ in channel region 29 in which the inversion layer is to be formed is not less than $I \times 10^{16}$ cm$^{-3}$ and not more than $2 \times 10^{18}$ cm$^{-3}$, and channel length L is not less than d defined by Formula (3) and not more than 0.43 $\mu$m, thereby suppressing occurrence of a short channel effect and reducing channel resistance. In this way, MOSFET 1 is a semiconductor device having reduced channel resistance.

Further, in MOSFET 1, a relation between electron mobility $\mu$, in the inversion layer and acceptor concentration $N_a$ in channel region 29 of p type body region 22 in which the inversion layer is to be formed preferably can be approximated by $1/\mu$ = Aexp(B·Na), where A and B represent constants of positive real numbers. Preferably, the value of B is more than $1 \times 10^{-19}$ and less than $1 \times 10^{-16}$. In addition, preferably, the value of A is more than 0 and less than 2. Further, the values of C and D preferably satisfy $0.5 < C < 1.0$ and $1 \times 10^{14} < D < 1 \times 10^{16}$, respectively. By satisfying these conditions, the short channel effect can be suppressed and the channel resistance can be reduced more securely in MOSFET 1.

More specifically, in MOSFET 1, for example, $1.7 \times 10^{-18}$ can be used as the value of B and 0.98 can be used as the value of C. An optimum acceptor density $N_a$ in this case can be calculated based on Formula (4) to be $5.8 \times 10^{17}$ cm$^{-3}$. On this occasion, based on Formula (3), a minimum channel length L allowing for suppression of the short channel effect can be calculated to be 0.01 $\mu$m. By employing such acceptor density $N_a$ and channel length L, the channel resistance can be reduced to be 1/30 of the channel resistance obtained when acceptor density $N_a$ is set at, for example, $1 \times 10^{16}$ cm$^{-3}$ and channel length L is set at 0.5 $\mu$m.

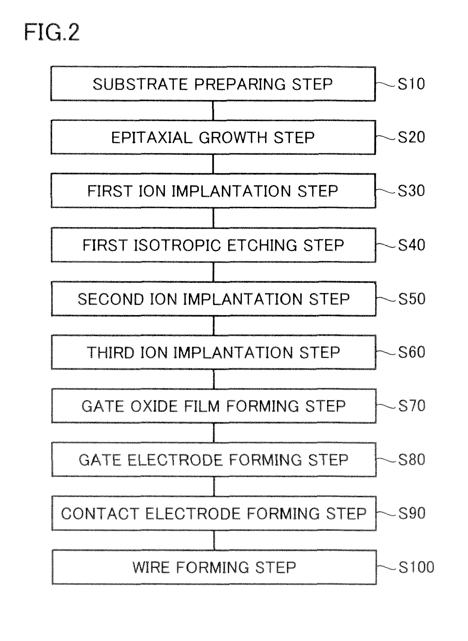

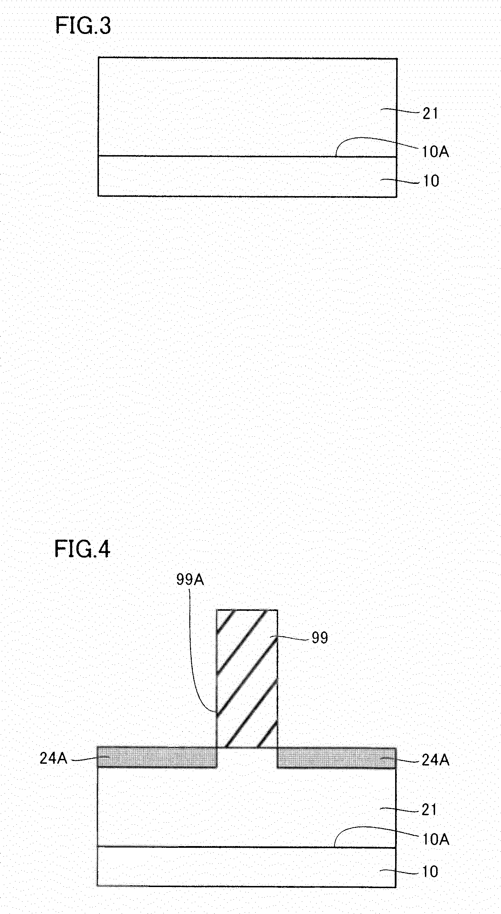

The following describes one exemplary method for manufacturing MOSFET 1 in the present embodiment, with reference to Fig. 2 to Fig. 9. Referring to Fig. 2, in the method for manufacturing MOSFET 1 of the present embodiment, a substrate preparing step is performed as a step (S10). In this step (S10), referring to Fig. 3, for example, silicon carbide substrate 10 is prepared which is obtained from a single-crystal silicon carbide ingot fabricated through a sublimation method and which has main surface 10A forming an angle of 8° or smaller relative to the (0001) plane.

Next, as a step (S20), an epitaxial growth step is performed. In this step (S20), referring to Fig. 3, drift layer 21 having n type conductivity is formed by epitaxial growth on one main surface 10A of silicon carbide substrate 10. Here, drift layer 21 can be given the n type conductivity by an n type impurity such as nitrogen or phosphorus.

Next, as a step (S30), a first ion implantation step is performed. In this step (S30), referring to Fig. 4, a mask layer 99 having openings 99A is first formed on drift layer 21. An exemplary, usable mask layer 99 is made of silicon dioxide. Thereafter, using mask layer 99 as a mask, ion implantation is performed to form n$^+$ regions 24A each containing an n type impurity at a concentration higher than that of drift layer 21.

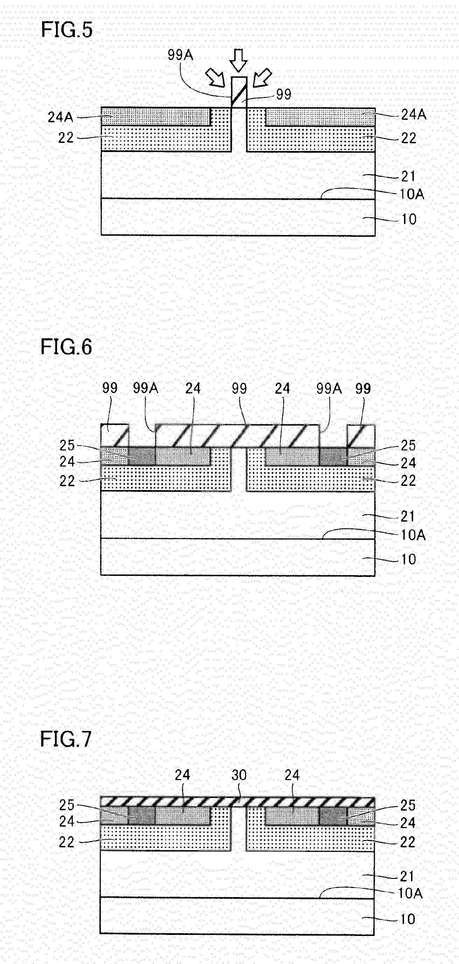

Next, as a step (S40), a first isotropic etching step is performed. In this step (S40), referring to Fig. 5, mask layer 99 used in step (S30) is subjected to isotropic etching to enlarge openings 99A as indicated by arrows therein.

Next, as a step (S50), a second ion implantation step is performed. In this step (S50), ion implantation is performed using, as a mask, mask layer 99 having openings 99A enlarged in step (S40). Accordingly, p type body regions 22 each containing a p type impurity are formed.

Next, as a step (S60), a third ion implantation step is performed. In this step (S60), referring to Fig. 6, mask layer 99 used in step (S50) is removed, and another mask layer 99 having openings 99A at appropriate locations is formed. Thereafter, using mask layer 99 as a mask, ion implantation is performed to form p$^+$ contact regions 25 each containing a p type impurity at a high concentration. On this occasion, in n$^+$ regions 24A, regions not having p$^+$ contact regions 25 thus formed become n$^+$ source regions 24.

Next, as a step (S70), a gate oxide film forming step is performed. In this step (S70), referring to Fig. 6 and Fig. 7, mask layer 99 used in step (S60) is removed, and then thermal oxidation treatment is performed to form a thermal oxidation film 30, which is to be formed into gate oxide film 30. This thermal oxidation film 30 is formed to cover the entire main surface of drift layer 21 opposite to silicon carbide substrate 10.

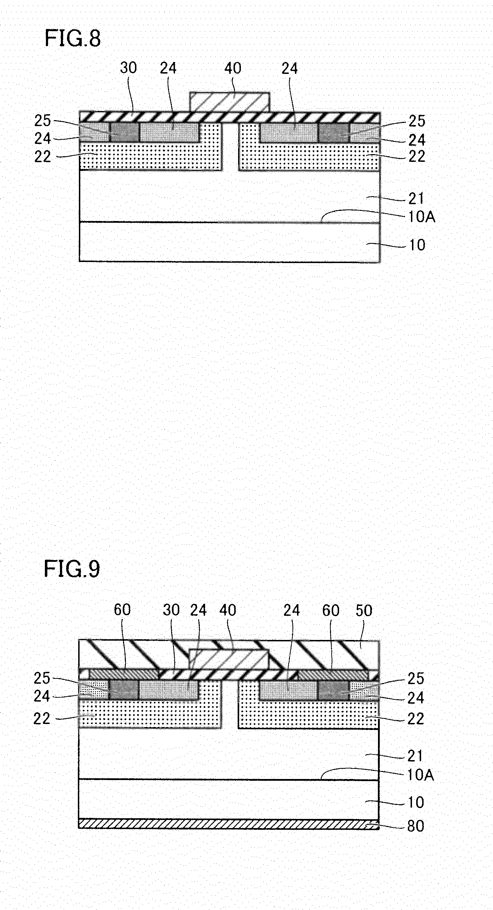

Next, as a step (S80), a gate electrode forming step is performed. In this step (S80), referring to Fig. 7 and Fig. 8, gate electrode 40 made of for example polysilicon is formed on and in contact with thermal oxidation film 30. Gate electrode 40 can be formed by means of, for example, sputtering.

Next, as a step (S90), a contact electrode forming step is performed. In this step (S90), referring to Fig. 8 and Fig. 9, source contact electrodes 60 and drain contact electrode 80 are formed. Specifically, first, portions of thermal oxidation film 30 above the regions of n$^+$ source regions 24 and p$^+$ contact regions 25 which are to be brought into contact with source contact electrode 60 are removed by etching. Next, for example, nickel layers are formed by means of a deposition method on the desired regions on which source contact electrodes 60 and drain contact electrode 80 are to be formed. Further, interlayer insulating film 50 made of silicon dioxide is formed to cover the upper surfaces of gate electrode 40, the nickel layers that are to be formed into source contact electrodes 60, and thermal oxidation film 30. Next, annealing for alloying is performed to silicide at least a portion of each of the nickel layers. In this way, there are formed source contact electrodes 60 forming an ohmic contact with n+ source regions 24, drain contact electrode 80 forming an ohmic contact with silicon carbide substrate 10, and interlayer insulating film 50.

Next, as a step (S100), a wire forming step is performed. In this step (S100), referring Fig. 9 and Fig. 1, source wire 70 and backside surface protecting electrode 90 are formed. Specifically, for example, portions of interlayer insulating film 50 on source contact electrodes 60 are removed, and then aluminum is deposited to cover source contact electrodes 60, interlayer insulating film 50, and drain contact electrode 80. With the above-described processes, the process for manufacturing MOSFET 1 of the present embodiment is completed. It should be noted that in the above-described manufacturing process, channel length L is determined by isotropic etching in step (S40). By setting channel length L at 0.1 $\mu$m or greater, the value of channel length L can be relatively readily controlled.

(Second Embodiment)

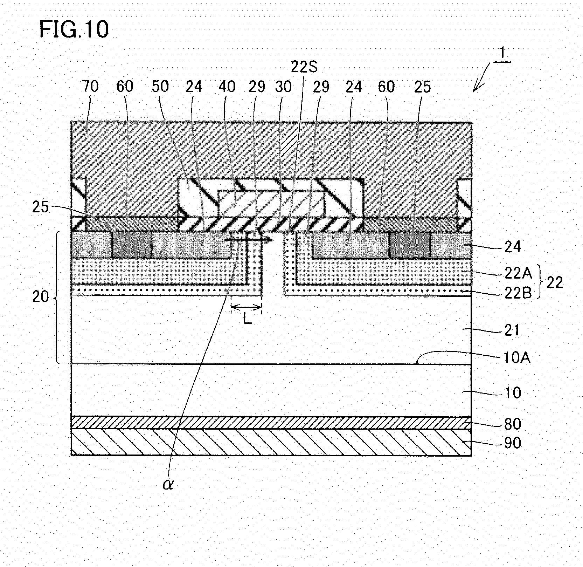

The following describes another embodiment of the present invention, i.e., a second embodiment. Referring to Fig. 10, a MOSFET 1, which is a semiconductor device in the second embodiment, has basically the same structure and provides basically the same effects as those of MOSFET 1 in the first embodiment. However, MOSFET 1 of the second embodiment is different from that of the first embodiment in terms of the configuration of each of p type body regions 22, in particular, the configuration of channel region 29.

Referring to Fig. 10, in MOSFET 1 of the second embodiment, each of p type body regions 22 includes: a high concentration region 22A containing acceptors at a high concentration; and a low concentration region 22B disposed to surround high concentration region 22A and containing acceptors at a concentration lower than that of high concentration region 22A. Further, gate oxide film 30 extends to make contact with n+ source regions 24, high concentration regions 22A, and low concentration regions 22B. Gate electrode 40 extends over high concentration region 22A and low concentration region 22B.

In other words, in MOSFET 1 of the second embodiment, each of p type body regions 22 is disposed to include channel region 29 in which the inversion layer is to be formed, and includes: high concentration region 22A having a high acceptor concentration; and low concentration region 22B disposed adjacent to high concentration region 22A in direction $\alpha$ in which electrons are moved in the inversion layer, so as to include channel region 29. Low concentration region 22B has a lower acceptor concentration than that of high concentration region 22A. In this way, in MOSFET 1 of the second embodiment, high concentration region 22A restrains the spreading width of the depletion layer in channel region 29 in which the inversion layer is to be formed, thereby suppressing occurrence of the short channel effect more securely.

Further, in MOSFET 1 of the present embodiment, the acceptor concentration in low concentration region 22B is preferably 1/2 or smaller of the acceptor concentration in high concentration region 22A. By disposing high concentration region 22A thus providing the large density difference, the short channel effect can be suppressed more securely.

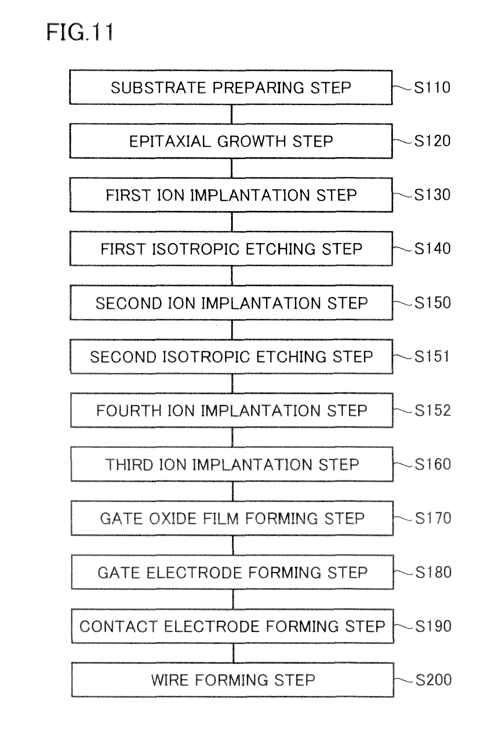

The following describes one exemplary method for manufacturing MOSFET 1 in the second embodiment, with reference to Fig. 11 to Fig. 13. Referring to Fig. 11, in the method for manufacturing MOSFET 1 in the second embodiment, a substrate preparing step corresponding to a step (S110), an epitaxial growth step corresponding to a step (S120), and a first ion implantation step corresponding to a step (S 130) are performed in the same manners as steps (S10), (S20), and (S30) of the first embodiment, respectively.

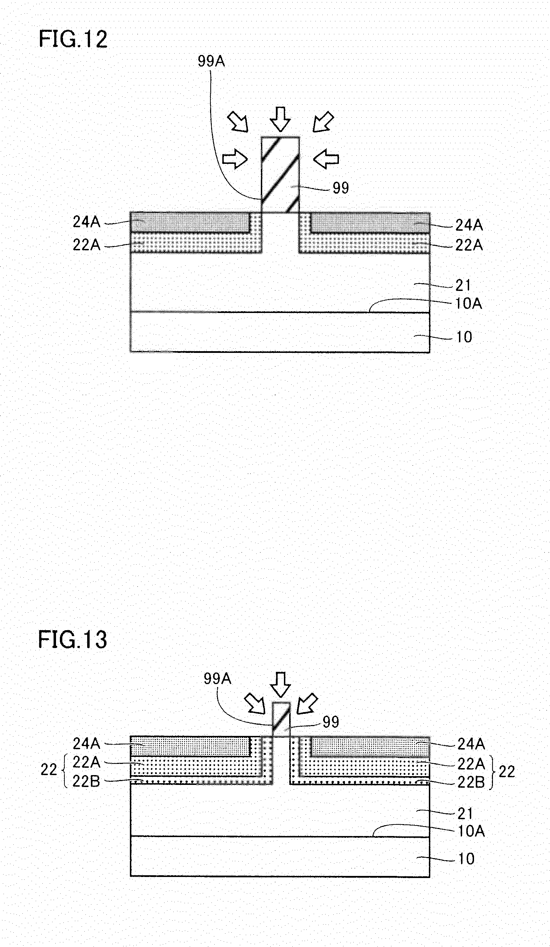

Next, as a step (S 140), a first isotropic etching step is performed. In this step (S 140), referring to Fig. 12, as indicated by arrows, by performing isotropic etching onto mask layer 99 used in step (S 130), openings 99A are enlarged to obtain openings 99A each corresponding to a desired shape of each of high concentration regions 22A.

Next, as a step (S 150), a second ion implantation step is performed. In this step (S 150), ion implantation is performed using, as a mask, mask layer 99 having openings 99A enlarged in step (S140). Accordingly, high concentration regions 22A each containing acceptors at a high concentration are formed. More specifically, in step (S 150), a high-concentration p type impurity is introduced by means of ion implantation, and then parts of the introduced impurity in a certain ratio serve as acceptors by subsequent activation annealing, thereby forming high concentration regions 22A.

Next, as a step (S 151), a second isotropic etching step is performed. In this step (S151), referring to Fig. 13, mask layer 99 used in step (S 150) is subjected to isotropic etching to enlarge openings 99A as indicated by arrows, thereby forming openings 99A each corresponding to a desired shape of each of low concentration regions 22B.

Next, as a step (S 152), a fourth ion implantation step is performed. In this step (S 152), ion implantation is performed using, as a mask, mask layer 99 having openings 99A enlarged in step (S151), thereby forming low concentration regions 22B each having an acceptor concentration lower than that of each of high concentration regions 22A. More specifically, in step (S152), a p type impurity having a lower concentration than that of each high concentration region 22A is introduced by means of ion implantation, and parts of the introduced impurity in a certain ratio serve as acceptors by subsequent activation annealing, thereby forming low concentration region 22B.

Thereafter, a third ion implantation step corresponding to a step (S 160), a gate oxide film forming step corresponding to a step (S 170), a gate electrode forming step corresponding to a step (S180), a contact electrode forming step corresponding to a step (S 190), and a wire forming step corresponding to a step (S200) are respectively performed in the same manners as steps (S60), (S70), (S80), (S90), and (S100) of the first embodiment. With the above-described processes, the process for manufacturing the semiconductor device of the present embodiment is completed, thus obtaining MOSFET 1 of the second embodiment as shown in Fig. 10.

In each of the above-described embodiments, it has been illustrated that the semiconductor device of the present invention is applied to a DMOSFET (planer type MOSFET), but the semiconductor device of the present invention is not limited to this. The semiconductor device of the present invention is applicable to various semiconductor devices each of which controls existence/non-existence of an inversion layer in an channel region in accordance with a predetermined threshold voltage so as to conduct and interrupt a current. Specifically, the semiconductor device of the present invention can be widely applied to semiconductor devices such as a trench type MOSFET (UMOSFET), a VMOSFET, and an IGBT.

The embodiments disclosed herein are illustrative and non-restrictive in any respect. The scope of the present invention is defined by the terms of the claims, rather than the embodiments described above, and is intended to include any modifications within the scope and meaning equivalent to the terms of the claims.

INDUSTRIAL APPLICABILITY

A semiconductor device of the present invention is particularly advantageously applicable to a semiconductor device required to allow for reduced on-resistance.

REFERENCE SIGNS LIST

1: MOSFET; 10: silicon carbide substrate; 10A: main surface; 20: active layer; 21: drift layer; 22: p type body region; 22A: high concentration region; 22B: low concentration region; 22S: surface; 24: $n^+$ source region; 24A: $n^+$ region; 25: $p^+$ contact region; 29: channel region; 30: gate oxide film (thermal oxidation film); 40: gate electrode; 50: interlayer insulating film; 60: source contact electrode; 70: source wire; 80: drain contact electrode; 90: backside surface protecting electrode; 99: mask layer; 99A: opening.

**Claims**

1. A semiconductor device (1) comprising:

   a substrate (10) made of silicon carbide;
   an epitaxial growth layer (20) made of silicon carbide and formed on said substrate (10);
   a gate insulating film (30) made of an insulator and disposed in contact with said epitaxial growth layer (20); and
   a gate electrode (40) disposed in contact with said gate insulating film (30),
   said epitaxial growth layer (20) including a p type body region (22) having p type conductivity and having a region which makes contact with said gate insulating film (30) and in which an inversion layer is formed when said gate electrode (40) is fed with a voltage,
   said inversion layer having an electron mobility $\mu$ dependent more strongly on an acceptor concentration $N_a$ in the region (29) of said p type body region (22) in which said inversion layer is to be formed, as compared with a dependency of the electron mobility $\mu$ being in proportional to a reciprocal of said acceptor concentration $N_a$,
   the acceptor concentration $N_a$ in the region (29) of said p type body region (22) in which said inversion layer is to be formed being not less than $1 \times 10^{16}$ cm$^{-3}$ and not more than $2 \times 10^{18}$ cm$^{-3}$,
   said inversion layer having a channel length (L) of 0.43 $\mu$m or smaller, said channel length (L) being a length thereof in a direction in which electrons are moved in said inversion layer,
   said channel length (L) being equal to or longer than a spreading width d of a depletion layer in the region (29) of said p type body region (22) in which said inversion layer is to be formed, said spreading width d being expressed by:

$$d = D \cdot N_a^{-C},$$

   where C and D represent constants.

2. The semiconductor device (1) according to claim 1, wherein a relation between the electron mobility $\mu$ in said inversion layer and the acceptor concentration $N_a$ in the region (29) of said p type body region (22) in which said inversion layer is to be formed is able to be approximated by the following formula:

$$1/\mu = A\exp(B \cdot N_a),$$

where A and B represent constants of real numbers.

3. The semiconductor device (1) according to claim 2, wherein a value of B is more than $1 \times 10^{-19}$ and less than $1 \times 10^{-16}$.

4. The semiconductor device (1) according to claim 2, wherein a value of A is more than 0 and less than 2.

5. The semiconductor device (1) according to claim 1, wherein values of C and D satisfy $0.5 < C < 1.0$ and $1 \times 10^{14} < D < 1 \times 10^{16}$, respectively.

6. The semiconductor device (1) according to claim 1, wherein:

said p type body region (22) includes
a high concentration region (22A) disposed to include the region (29) in which said inversion layer is to be formed and having a high acceptor concentration $N_a$, and
a low concentration region (22B) disposed adjacent to said high concentration region (22A) in the direction in which the electrons are moved in said inversion layer, so as to include the region (29) in which said inversion layer is to be formed, said low concentration region (22B) having a lower acceptor concentration $N_a$ than that of said high concentration region (22A).

7. The semiconductor device (1) according to claim 6, wherein the acceptor concentration $N_a$ in said low concentration region (22B) is 1/2 or smaller of the acceptor concentration $N_a$ in said high concentration region (22A).

8. A semiconductor device (1) comprising:

a substrate (10) made of silicon carbide;
an epitaxial growth layer (20) made of silicon carbide and formed on said substrate (10);
a gate insulating film (30) made of an insulator and disposed in contact with said epitaxial growth layer (20); and
a gate electrode (40) disposed in contact with said gate insulating film (30),
said epitaxial growth layer (20) including a p type body region (22) having p type conductivity and having a region which makes contact with said gate insulating film (30) and in which an inversion layer is formed when said gate electrode (40) is fed with a voltage,
said epitaxial growth layer (20) having a surface (22S) that faces said gate electrode (40) with said gate insulating film (30) interposed therebetween and that forms an angle of 8° or smaller relative to a (0001) plane of silicon carbide constituting said epitaxial growth layer (20),
an acceptor concentration $N_a$ in the region (29) of said p type body region (22) in which said inversion layer is to be formed being not less than $1 \times 10^{16}$ cm$^{-3}$ and not more than $2 \times 10^{18}$ cm$^{-3}$,
said inversion layer having a channel length (L) of 0.43 $\mu$m or smaller, said channel length (L) being a length thereof in a direction in which electrons are moved in said inversion layer,
said channel length (L) being equal to or longer than a spreading width d of a depletion layer in the region of said p type body region (22) in which said inversion layer is to be formed, said spreading width d being expressed by:

$$d = D \cdot N_a^{-C},$$

where C and D represent constants.

9. The semiconductor device (1) according to claim 8, wherein values of C and D satisfy $0.5 < C < 1.0$ and $1 \times 10^{14} < D < 1 \times 10^{16}$, respectively.

**10.** The semiconductor device (1) according to claim 8, wherein:

said p type body region (22) includes
a high concentration region (22A) disposed to include the region (29) in which said inversion layer is to be formed and having a high acceptor concentration $N_a$, and
a low concentration region (22B) disposed adjacent to said high concentration region (22A) in the direction in which the electrons are moved in said inversion layer, so as to include the region (29) in which said inversion layer is to be formed, said low concentration region (22B) having a lower acceptor concentration $N_a$ than that of said high concentration region (22A).

**11.** The semiconductor device (1) according to claim 10, wherein the acceptor concentration $N_a$ in said low concentration region (22B) is 1/2 or smaller of the acceptor concentration $N_a$ in said high concentration region (22A).

FIG.1

FIG.2

```
┌─────────────────────────────────────┐
│      SUBSTRATE PREPARING STEP        │─── S10
└─────────────────────────────────────┘
                   │
┌─────────────────────────────────────┐
│       EPITAXIAL GROWTH STEP          │─── S20
└─────────────────────────────────────┘
                   │
┌─────────────────────────────────────┐
│     FIRST ION IMPLANTATION STEP      │─── S30
└─────────────────────────────────────┘
                   │
┌─────────────────────────────────────┐
│     FIRST ISOTROPIC ETCHING STEP     │─── S40
└─────────────────────────────────────┘
                   │
┌─────────────────────────────────────┐
│     SECOND ION IMPLANTATION STEP     │─── S50
└─────────────────────────────────────┘
                   │
┌─────────────────────────────────────┐
│     THIRD ION IMPLANTATION STEP      │─── S60
└─────────────────────────────────────┘
                   │
┌─────────────────────────────────────┐
│     GATE OXIDE FILM FORMING STEP     │─── S70
└─────────────────────────────────────┘
                   │
┌─────────────────────────────────────┐
│     GATE ELECTRODE FORMING STEP      │─── S80
└─────────────────────────────────────┘
                   │
┌─────────────────────────────────────┐
│    CONTACT ELECTRODE FORMING STEP    │─── S90
└─────────────────────────────────────┘
                   │
┌─────────────────────────────────────┐
│          WIRE FORMING STEP           │─── S100
└─────────────────────────────────────┘
```

FIG.3

21
10A
10

FIG.4

99A
99
24A
24A
21
10A
10

FIG.5

FIG.6

FIG.7

FIG.8

FIG.9

FIG.10

70  60  50  24  40  29  30  29  24  60  25

22S

1

25

25

24

22A  } 22
22B

20

L

21

10A

10

80

90

α

## FIG.11

| | |
|---|---|
| SUBSTRATE PREPARING STEP | ~S110 |
| EPITAXIAL GROWTH STEP | ~S120 |
| FIRST ION IMPLANTATION STEP | ~S130 |
| FIRST ISOTROPIC ETCHING STEP | ~S140 |
| SECOND ION IMPLANTATION STEP | ~S150 |
| SECOND ISOTROPIC ETCHING STEP | ~S151 |
| FOURTH ION IMPLANTATION STEP | ~S152 |
| THIRD ION IMPLANTATION STEP | ~S160 |
| GATE OXIDE FILM FORMING STEP | ~S170 |
| GATE ELECTRODE FORMING STEP | ~S180 |
| CONTACT ELECTRODE FORMING STEP | ~S190 |
| WIRE FORMING STEP | ~S200 |

FIG.12

99A

99

24A

22A

24A

22A

21

10A

10

FIG.13

99A

99

24A

22A

22B

24A

22A

22B

22

22

21

10A

10

# EP 2 672 516 A1

<table>
<tr><td colspan="2" align="center"><b>INTERNATIONAL SEARCH REPORT</b></td><td>International application No.<br>PCT/JP2011/072992</td></tr>
</table>

**A. CLASSIFICATION OF SUBJECT MATTER**
*H01L29/12*(2006.01)i, *H01L21/336*(2006.01)i, *H01L29/78*(2006.01)i

According to International Patent Classification (IPC) or to both national classification and IPC

**B. FIELDS SEARCHED**

Minimum documentation searched (classification system followed by classification symbols)
H01L29/12, H01L21/336, H01L29/78

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2005-252157 A  (Mitsubishi Electric Corp.),<br>15 September 2005 (15.09.2005),<br>paragraphs [0009] to [0030]; fig. 1 to 6<br>(Family: none) | 1,5<br>2-4,6-11 |
| Y | WO 2007/046254 A1  (Mitsubishi Electric Corp.),<br>26 April 2007 (26.04.2007),<br>fig. 16; paragraph [0112]<br>& US 2009/0173997 A1 | 2-4 |
| Y | JP 2009-54765 A  (Mitsubishi Electric Corp.),<br>12 March 2009 (12.03.2009),<br>fig. 1; paragraphs [0010] to [0021]<br>(Family: none) | 6-7,10-11 |

☒ Further documents are listed in the continuation of Box C.　　　☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>01 December, 2011 (01.12.11) | Date of mailing of the international search report<br>13 December, 2011 (13.12.11) |
|---|---|
| Name and mailing address of the ISA/<br>　　Japanese Patent Office | Authorized officer |
| Facsimile No. | Telephone No. |

Form PCT/ISA/210 (second sheet) (July 2009)

20

**INTERNATIONAL SEARCH REPORT**

International application No.

PCT/JP2011/072992

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | JP 2010-135789 A (Cree Inc.),<br>17 June 2010 (17.06.2010),<br>paragraphs [0034], [0046]<br>& WO 2010/065334 A2    & US 2010/0133549 A1<br>& EP 2192211 A1 | 8-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2000150866 A

### Non-patent literature cited in the description

- **FUJIHIRA et al.** Realization of Low On-Resistance 4H-SiC power MOSFETs by Using Retrograde Profile in P-Body. *Materials Science Forum, Vols.556-557, Silicon Carbide and Related Materials 2006,* 2006, vol. 556-557, 827-830

- **SEI-HYUNG RYU et al.** Critical Issues for MOS Based Power Devices in 4H-SiC. *Materials Science Forum,* 2009, vol. 615-617, 743-748